# EUROPEAN PATENT APPLICATION

(11) **EP 4 167 493 A1**
(43) Date of publication of application: **19.04.2023**
(21) Application number: 21831728.7
(22) Date of filing: 06.05.2021
(51) Int. Cl.: H04B 1/40, H04B 1/401

(54) **TRANSCEIVER AND CONTROL METHOD THEREFOR, AND COMPUTER READABLE STORAGE MEDIUM**

(30) Priority: 30.06.2020 CN 202010619434
(71) Applicant: ZTE Corporation, Shenzhen, Guangdong 518057 (CN)
(72) Inventor: HUANG, Yang, Shenzhen, Guangdong 518057 (CN); TIAN, Shen, Shenzhen, Guangdong 518057 (CN); YE, Yong, Shenzhen, Guangdong 518057 (CN); GUO, Xiaoyu, Shenzhen, Guangdong 518057 (CN); JIN, Hefei, Shenzhen, Guangdong 518057 (CN); HU, Xuedong, Shenzhen, Guangdong 518057 (CN)
(74) Representative: Savi, Massimiliano
(86) International application number: PCT/CN2021/091936
(87) International publication number: WO 2022/001361

(57) **Abstract**

A transceiver and a control method therefor, and a computer-readable storage medium. The transceiver includes a main local oscillator module (1010), an auxiliary local oscillator module (1020), a first-type signal transmission link (1030), a second-type signal transmission link (1040), and a control processing module (1090).

## Description

### CROSS-REFERENCE TO RELATED APPLICATION

This application is filed on the basis of Chinese patent application No. 202010619434.5 filed on June 30, 2020, and claims priority to the Chinese patent application, the entire contents of which are incorporated herein by reference.

### TECHNICAL FIELD

Embodiments of the present disclosure relate to, but are not limited to, the technical field of communication, and in particular, to a transceiver and a control method therefor, and a computer-readable storage medium.

### BACKGROUND

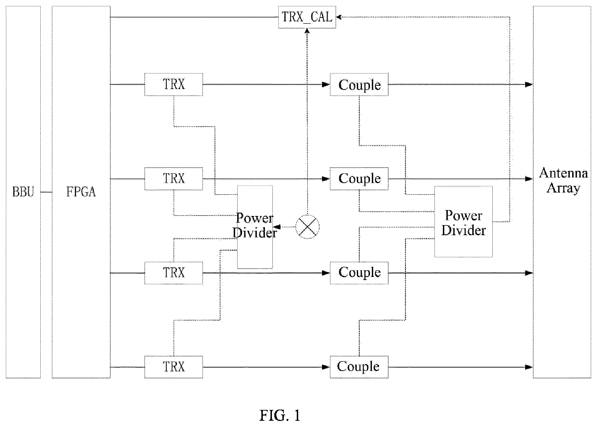

In some cases, a 5G millimeter wave multi-channel transceiver has a typical architecture as shown in FIG. 1. A local oscillator signal is configured by means of a phase-locked loop chip. The local oscillator signal, after passing through a power divider, is used as a local oscillator signal of frequency conversion modules of multiple transceiver channels. Therefore, if the frequency of an Intermediate Frequency (IF) signal in each transceiver channel is fixed and consistent, frequencies of radio frequency signals in multiple transceiver channels can be consistent. If the frequencies of the radio frequency signals need to be changed, local oscillator signals of different frequencies may be configured or the frequencies of the IF signals may be changed.

However, in the case of fixed bandwidths of the IF signals, bandwidths of the radio frequency signals cannot be widened in the above manner. If the bandwidths of the radio frequency signals need to be widened, the bandwidths of the IF signals need to be widened. To widen the bandwidths of the IF signals, sampling rates of a digital-to-analog converter and an analog-to-digital converter need to be further increased. However, the digital-to-analog converter and the analog-to-digital converter with higher sampling rates are more expensive, which is not conducive to cost reduction. Moreover, there is a higher requirement for image frequency suppression when IF signals with wider bandwidth are subjected to digital-to-analog conversion or analog-to-digital conversion. In addition, more software resources will be consumed when the IF signals with wider bandwidth are subjected to digital up-conversion and digital down-conversion.

### SUMMARY

The following is an overview of subject matters described in detail herein. The overview is not intended to limit the protection scope of the claims.

According to some embodiments of the present disclosure, a transceiver and a control method therefor, and a computer-readable storage medium are provided, which can widen bandwidths of Radio Frequency (IF) signals without changing bandwidths of IF signals.

In accordance with an aspect of the present disclosure, an embodiment provides a transceiver. The transceiver includes: at least one main local oscillator module; at least one auxiliary local oscillator module; at least one first-type signal transmission link including a first-type mixer, and the first-type mixer connected to the main local oscillator module; at least one second-type signal transmission link including a second-type mixer connected to the auxiliary local oscillator module; and a control processing module connected to the main local oscillator module and the auxiliary local oscillator module, and configured to configure the main local oscillator module and the auxiliary local oscillator module with different operating frequencies according to an Instantaneous Bandwidth (IBW).

In accordance with another aspect of the present disclosure, an embodiment further provides a control method for a transceiver. The transceiver includes at least one main local oscillator module, at least one auxiliary local oscillator module, at least one first-type signal transmission link, and at least one second-type signal transmission link. The first-type signal transmission link includes a first-type mixer connected to the main local oscillator module. The second-type signal transmission link includes a second-type mixer connected to the auxiliary local oscillator module. The control method includes acquiring an IBW, and configuring the main local oscillator module and the auxiliary local oscillator module with different operating frequencies according to the IBW.

In accordance with another aspect of the present disclosure, an embodiment further provides a computer-readable storage medium storing a computer-executable instruction which, when executed by a processor, causes the processor to implement the control method as described above.

Other features and advantages of the present disclosure will be set forth in the description which follows and in part will become apparent from the description or may be learned from practice of the present disclosure. The objectives and other advantages of the present disclosure may be realized and attained by the structure particularly pointed out in the description, claims, and the accompanying drawings.

### BRIEF DESCRIPTION OF DRAWINGS

FIG. 1 is a schematic diagram of a typical architecture of an existing 5G millimeter wave multi-channel transceiver;
FIG. 2 is a schematic structural diagram of a transceiver according to an embodiment of the present disclosure;
FIG. 3 is a schematic structural diagram of a transceiver according to another embodiment of the present disclosure;
FIG. 4 is a flowchart of a control method for a transceiver according to an embodiment of the present disclosure;
FIG. 5 is a flowchart of a control method for a transceiver according to another embodiment of the present disclosure; and
FIG. 6 is a flowchart of a control method for a transceiver according to another embodiment of the present disclosure.

### Reference numerals:

main local oscillator module 1010, auxiliary local oscillator module 1020, first-type signal transmission link 1030, first-type mixer 1031, second-type signal transmission link 1040, second-type mixer 1041, first power divider 1050, fourth power divider 1060, second switch module 1080, first switch module 1070, control processing module 1090, antenna array 1110, Base Band Unit (BBU) 1120, second power divider 1130, coupling module 1140, coupler 1141, and third power divider 1150.

### DETAILED DESCRIPTION

In order to make the objectives, technical schemes, and advantages of the present disclosure clear, the present disclosure is described in further detail below in conjunction with the accompanying drawings and embodiments. It should be understood that specific embodiments described herein are only used to illustrate the present disclosure and are not intended to limit the present disclosure.

It is to be noted, although functional modules have been divided in the schematic diagrams of apparatuses and logical orders have been shown in the flowcharts, in some cases, the modules may be divided in a different manner, or the steps shown or described may be executed in an order different from the orders as shown in the flowcharts. The terms such as "first", "second" and the like in the description, the claims, and the accompanying drawings are used to distinguish similar objects, and are not necessarily used to describe a specific sequence or a precedence order.

According to some embodiments of the present disclosure, a transceiver and a control method therefor, and a computer-readable storage medium are provided. The transceiver includes a main local oscillator module 1010, an auxiliary local oscillator module 1020, a first-type signal transmission link 1030, a second-type signal transmission link 1040, and a control processing module 1090. The first-type signal transmission link 1030 includes a first-type mixer 1031. The first-type mixer 1031 is connected to the main local oscillator module 1010. The second-type signal transmission link 1040 includes a second-type mixer 1041. The second-type mixer 1041 is connected to the auxiliary local oscillator module 1020. The control processing module 1090 is connected to the main local oscillator module 1010 and the auxiliary local oscillator module 1020 and configured to configure the main local oscillator module 1010 and the auxiliary local oscillator module 1020 with different operating frequencies according to an Instantaneous Bandwidth (IBW). In a case where an IF bandwidth is not changed, by controlling an operating frequency of the local oscillator module, requirements for the sampling rates of a digital-to-analog converter and an analog-to-digital converter are reduced, a requirement for image frequency suppression in digital-to-analog conversion or analog-to-digital conversion is reduced, and software resources to be consumed when IF signals are subjected to digital up-conversion and digital down-conversion are reduced, so that 5G millimeter wave signals in different frequency bands can be transmitted and received.

The embodiments of the present disclosure are further elaborated below in conjunction with the accompanying drawings.

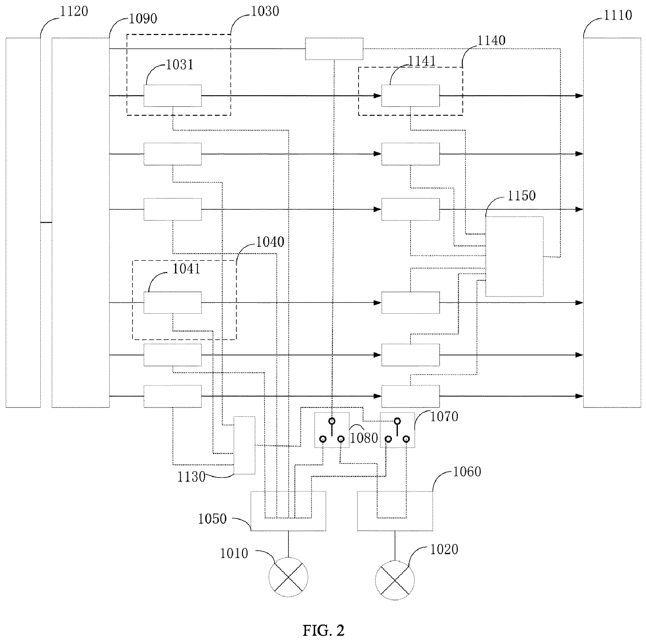

As shown in FIG. 2, FIG. 2 is a schematic structural diagram of a transceiver according to an embodiment of the present disclosure. In the example of FIG. 2, the transceiver includes a main local oscillator module 1010, an auxiliary local oscillator module 1020, a first-type signal transmission link 1030, a second-type signal transmission link 1040, and a control processing module 1090. The first-type signal transmission link 1030 is provided with a first-type mixer 1031. The second-type signal transmission link 1040 is provided with a second-type mixer 1041. The first-type mixer 1031 is connected to the main local oscillator module 1010, and the second-type mixer 1041 is connected to the auxiliary local oscillator module 1020. The control processing module 1090 is connected to the main local oscillator module 1010 and the auxiliary local oscillator module 1020, respectively.

In some embodiments, the main local oscillator module 1010 includes at least one main local oscillator. The main local oscillator module 1010 is configured to provide local oscillator signals for the first-type signal transmission link 1030 and the second-type signal transmission link 1040 when the transceiver uplinks and downlinks signals.

In some embodiments, the auxiliary local oscillator module 1020 includes at least one auxiliary local oscillator. The auxiliary local oscillator module 1020 is configured to provide a local oscillator signal for part of the second-type signal transmission link 1040 when a double local oscillator is enabled.

In some embodiments, the control processing module 1090 includes a Field Programmable Gate Array (FPGA).

In some embodiments, the transceiver further includes a Base band Unit (BBU) 1120. The BBU 1120 is configured to implement functions such as channel encoding and decoding, modulation and demodulation of base band signals, and protocol processing and the like, and provide a function of interfacing with an upper-layer network element at the same time.

In some embodiments, the transceiver is further connected to an antenna array 1110. The antenna array 1110 includes antenna arrays required by various cell structures, such as an omnidirectional antenna array, a sector antenna array, a star antenna array, a chain antenna array, and the like. It is to be noted that the antenna array 1110 in this embodiment may adopt an antenna array for transmitting and receiving 2G signals, 3G signals, 4G signals, or 5G Sub 6 GHz signals in some cases, which belongs to a conventional design in the art, and will not be described in detail herein.

In some embodiments, the FPGA in the transceiver determines whether a required IBW is greater than an IF bandwidth. If the required IBW is less than or equal to the IF bandwidth, a first switch is switched to a first fixed contact of the first switch to cause the main local oscillator of the transceiver to provide a local oscillator signal in a link, and a frequency of the main local oscillator is set to cause different channels of the transceiver to be at the same frequency. If the IBW required is greater than the IF bandwidth, the first switch is switched to a second fixed contact of the first switch to cause the main local oscillator and the auxiliary local oscillator to provide local oscillator signals in uplink and downlink conversion in the link, so as to match the IBW The FPGA sets operating frequencies of the main local oscillator and the auxiliary local oscillator respectively according to the IBW. Part of the local oscillator signals in the transceiver is provided by the main local oscillator, and the other part is provided by the auxiliary local oscillator. The IF bandwidth of the transceiver can be adjusted using a double local oscillator operating mode of the transceiver, so as to improve a processing capability of the transceiver for the IF bandwidth, which increases a range of the IF bandwidth of the transceiver.

In some embodiments, the transceiver further includes at least one first power divider 1050 and at least one second power divider 1130. The first-type mixer 1031 is connected with the main local oscillator module 1010 by means of the first power divider 1050, and the second-type mixer 1041 is connected with the auxiliary local oscillator module 1020 by means of the second power divider 1130.

In some embodiments, the first power divider 1050 is configured to divide power of the main local oscillator module 1010. The first power divider 1050 is connected to the main local oscillator module 1010 and the first-type mixer 1031, respectively.

In some embodiments, the second power divider 1130 is configured to divide power of the auxiliary local oscillator module 1020. The second power divider 1130 is connected to the auxiliary local oscillator module 1020 and the second-type mixer 1041, respectively.

In some embodiments, the transceiver further includes at least one first switch module 1070. The first switch module 1070 includes a first switch control terminal, a first switch movable contact, a first fixed contact of the first switch, and a second fixed contact of the first switch. The first switch movable contact is connected to the second power divider 1130, the first fixed contact of the first switch is connected to the first power divider 1050, the second fixed contact of the first switch is connected to the auxiliary local oscillator module 1020, and the first switch control terminal is connected to the control processing module 1090.

In an embodiment, when the IBW is less than the IF bandwidth, the control processing module 1090 may control the first switch control terminal to connect the first switch module 1070 to the first fixed contact of the first switch. That is, only the main local oscillator is utilized to provide local oscillator signals in channel uplink and downlink conversion, and the auxiliary local oscillator is turned off to reduce power consumption of the transceiver. Moreover, the frequency of the main local oscillator module 1010 is adjusted such that the local oscillator signals of the transceiver are all provided by the main local oscillator module 1010 and different channels of the transceiver are at the same frequency to complete transmission and receiving of millimeter wave signals, so as to achieve compatibility of the transceiver in some cases.

In an embodiment, when the IBW is greater than the IF bandwidth, the control processing module 1090 may control the first switch control terminal to connect the first switch module 1070 to the second fixed contact of the first switch. That is, both the main local oscillator module 1010 and the auxiliary local oscillator module 1020 are utilized to provide the local oscillator signals in the channel uplink and downlink conversion, so as to acquire a greater IF bandwidth. Moreover, frequencies of the main local oscillator module 1010 and the auxiliary local oscillator module 1020 are adjusted such that the local oscillator signals in the transceiver are provided by the main local oscillator module 1010 and the auxiliary local oscillator module 1020 respectively to complete transmission and receiving of the millimeter wave signals. The IF bandwidth of the transceiver is adjusted using a double local oscillator module, so that the IF bandwidth of the transceiver can be increased without using an analog-to-digital converter and a digital-to-analog converter with higher sampling rates, thereby increasing a signal bandwidth of the transceiver.

In some embodiments, the first switch module 1070 may adopt a single-pole double-throw switch. The use of the single-pole double-throw switch can realize direct switching between the first fixed contact of the first switch and the second fixed contact of the first switch, i.e., switching between the first power divider 1050 and the second power divider 1130, and thus realize switching between using only the main local oscillator module 1010 and using both the main local oscillator module 1010 and the auxiliary local oscillator module 1020, and increase a space utilization rate of the product.

In some embodiments, the transceiver further includes a second switch module 1080, a third power divider 1150, and a calibration link configured to calibrate a transmission signal. The calibration link is coupled with the first-type signal transmission link 1030 and the second-type signal transmission link 1040 respectively by means of the third power divider 1150. The calibration link includes a calibration mixer. The calibration mixer is connected with the main local oscillator module 1010 and the auxiliary local oscillator module 1020 by means of the second switch module 1080.

In some embodiments, the transceiver further includes a single local oscillator transmission calibration mode. In the single local oscillator transmission calibration mode, the second switch module 1080 adjusts the calibration link by adjusting the third power divider 1150, and changes an operating mode of the transceiver to the single local oscillator transmission calibration mode. The transceiver simultaneously transmits multiple digital-to-analog signals including a calibration sequence and converts the transmission signals into millimeter wave signals. The calibration mixer in the calibration link couples the multiple millimeter wave signals into one millimeter wave signal. The control processing module 1090 parses the coupled millimeter wave signal to form an IF signal in the first-type signal transmission link 1030, and performs analog-to-digital signal sampling on the IF signal in the first-type signal transmission link 1030. Then, the control processing module 1090 analyzes the sampled signal, and adjusts delay and gain in the first-type signal transmission link 1030 according to an analysis result to compensate for signal amplitude and phase in the link. In the single local oscillator transmission calibration mode, when the transceiver transmits and receives a millimeter-wave signal by utilizing a single local oscillator, the signals transmitted can be calibrated, which increases a recognition rate of signals and reduces the requirement for signal demodulation.

In some embodiments, the transceiver further includes a single local oscillator receiving calibration mode. In the single local oscillator receiving calibration mode, the second switch module 1080 adjusts the calibration link by adjusting a fifth power divider, and changes an operating mode of the transceiver to the single local oscillator receiving calibration mode. The transceiver transmits a digital-to-analog signal including a calibration sequence and converts a received signal into a millimeter wave signal through a fourth power divider 1060. The calibration mixer in the calibration link couples multiple millimeter wave signals into one millimeter wave signal. The control processing module 1090 parses the coupled millimeter wave signal to form an IF signal in the first-type signal transmission link 1030, and performs analog-to-digital signal sampling on the IF signal in the first-type signal transmission link 1030. Then, the control processing module 1090 analyzes the sampled signal, and adjusts delay and gain in the first-type signal transmission link 1030 according to an analysis result to compensate for signal amplitude and phase in the link. In the single local oscillator receiving calibration mode, when the transceiver transmits and receives signals by utilizing a single local oscillator, the signals received can be calibrated, which increases a recognition rate of the transceiver for the received signals.

In some embodiments, the transceiver further includes the fourth power divider 1060. The second switch module 1080 includes a second switch control terminal, a second switch movable contact, a first fixed contact of the second switch, and a second fixed contact of the second switch. The second switch movable contact is connected to the calibration mixer. The first fixed contact of the second switch is connected to the first power divider 1050. The second fixed contact of the second switch is connected with the auxiliary local oscillator module 1020 by means of the fourth power divider 1060. The second switch control terminal is connected to the control processing module 1090.

In some embodiments, the transceiver further includes a double local oscillator transmission calibration mode. In the double local oscillator transmission calibration mode, the second switch module 1080 adjusts the calibration link, and changes an operating mode of the transceiver to the double local oscillator transmission calibration mode. The transceiver simultaneously transmits multiple digital-to-analog signals including a calibration sequence and converts the transmission signals into millimeter wave signals through the fourth power divider 1060. The calibration mixer in the calibration link couples the multiple millimeter wave signals into one-millimeter wave signal. The control processing module 1090 parses the coupled millimeter wave signal to form an IF signal in the first-type signal transmission link 1030, and performs analog-to-digital signal sampling on the IF signal in the first-type signal transmission link 1030. Then, the control processing module 1090 analyzes the sampled signal, and adjusts delay and gain in the first-type signal transmission link 1030 according to an analysis result to compensate for signal amplitude and phase in the link. In the double local oscillator transmission calibration mode, transmission signals of the double local oscillator in the transceiver can be calibrated, which improves transmission accuracy of the transceiver in the double local oscillator transmission mode.

In some embodiments, the second switch module 1080 may adopt a single-pole double-throw switch. The use of the single-pole double-throw switch can realize direct switching between the first fixed contact of the second switch and the second fixed contact of the second switch, i.e., switching between the first power divider 1050 and the fourth power divider 1060, and thus realize switching between using only the main local oscillator module 1010 and using both the main local oscillator module 1010 and the auxiliary local oscillator module 1020, and save an internal space of the product.

In some embodiments, the transceiver further includes a third switch module and a fourth switch module. Each of the first-type mixers 1031 is respectively connected to each of the first power dividers 1050 and each of the second power dividers 1130 by means of the third switch module, and each of the second-type mixers 1041 is respectively connected to each of the first power dividers 1050 and each of the second power dividers 1130 by means of the fourth switch module.

In some embodiments, the transceiver further includes a fifth switch module, a fifth power divider, and a calibration link configured to calibrate a transmission signal. The calibration link is respectively coupled with the first-type signal transmission link 1030 and the second-type signal transmission link 1040 by means of the fifth power divider. The calibration link includes a calibration mixer. The calibration mixer is connected with the main local oscillator module 1010 and the auxiliary local oscillator module 1020 by means of the fifth switch module.

In some embodiments, the transceiver further includes a double local oscillator receiving calibration mode. In the double local oscillator receiving calibration mode, the fifth switch module adjusts the calibration link by adjusting the fifth power divider, and changes an operating mode of the transceiver to the double local oscillator receiving calibration mode. The transceiver transmits a digital-to-analog signal including a calibration sequence and converts the transmission signal into a millimeter wave signal. The calibration mixer in the calibration link couples multiple millimeter wave signals into millimeter wave signals of which the number is half the number of links. The control processing module 1090 parses the coupled millimeter wave signals of which the number is half the number of the links to form an IF signal in the first-type signal transmission link 1030, and performs analog-to-digital signal sampling on the IF signal in the first-type signal transmission link 1030. Then, the control processing module 1090 analyzes the sampled signal, and adjusts delay and gain in the first-type signal transmission link 1030 according to an analysis result to compensate for signal amplitude and phase in the link. In the double local oscillator receiving calibration mode, accuracy of recognition of signals received by the transceiver in the double local oscillator receiving mode can be improved.

In some embodiments, the transceiver further includes a coupling module 1140. The coupling module 1140 includes at least one coupler 1141. The coupling module 1140 is configured to couple signals generated by the third power divider 1150 and the first-type mixer 1031. The coupling module 1140 is further configured to couple signals generated by the third power divider 1150 and the second-type mixer 1041.

In some embodiments, the transceiver further includes at least one sixth power divider and at least one seventh power divider. The main local oscillator module 1010 is connected with the first power divider 1050 and the fifth switch module by means of the sixth power divider, and the auxiliary local oscillator module 1020 is connected with the second power divider 1130 and the fifth switch module by means of the seventh power divider.

In some embodiments, the transceiver further includes a multi-local oscillator operating mode. For example, the transceiver includes M local oscillators, and a total of m local oscillators are enabled, where m<=M, and IF_BW denotes an IF bandwidth of a single local oscillator in the transceiver in the multi-local oscillator operating mode. When the transceiver is in the multi-local oscillator operating mode, the control processing module 1090 determines whether a required IBW is less than an IF bandwidth of a single local oscillator. If the required IBW is less than or equal to the IF bandwidth of a single local oscillator, a single local oscillator is enabled. Then, a local oscillator of the transceiver is enabled to provide local oscillator signals in the link, and a frequency of the local oscillator is set to cause different channels of the transceiver to be at the same frequency. It is determined whether the IBW satisfies m^{∗}IF_BW<IBW. If m^{∗}IF_BW<IBW, it is determined whether the IBW satisfies (m-1)^{∗}IF_BW<IBW<=m^{∗}IF_BW. If the required IBW is greater than the IF bandwidth of a single local oscillator, the first switch is switched to the second fixed contact of the first switch to cause the m local oscillators to provide local oscillator signals in uplink and downlink conversion in the link, so as to match the IBW. The control processing module 1090 sets operating frequencies of the main local oscillator and the auxiliary local oscillator respectively according to the IBW. Part of the local oscillator signals in the transceiver is provided by the main local oscillator, and the other part is provided by the auxiliary local oscillator. The IF bandwidth of the transceiver can be further adjusted using the multi-local oscillator operating mode of the transceiver, so as to improve the processing capability of the transceiver for the IF bandwidth, thereby realizing a full coverage of a millimeter wave IF bandwidth that the transceiver can handle.

In some embodiments, when the transceiver enables the multi-local oscillator operating mode, the first-type signal transmission link 1030 is identical with the second-type signal transmission link.

In some embodiments, when the transceiver is in the single local oscillator operating mode, an output bandwidth of the transceiver is an IF processing bandwidth, and a center frequency depends on a local oscillator frequency. When the transceiver is in a double local oscillator mode, an output spectrum of the transceiver is adjustable. The IF bandwidth of the transceiver can be adjusted by adjusting a frequency difference between the main local oscillator and the auxiliary local oscillator, so that the transceiver can adjust 5G millimeter wave transmitting and receiving frequency bands.

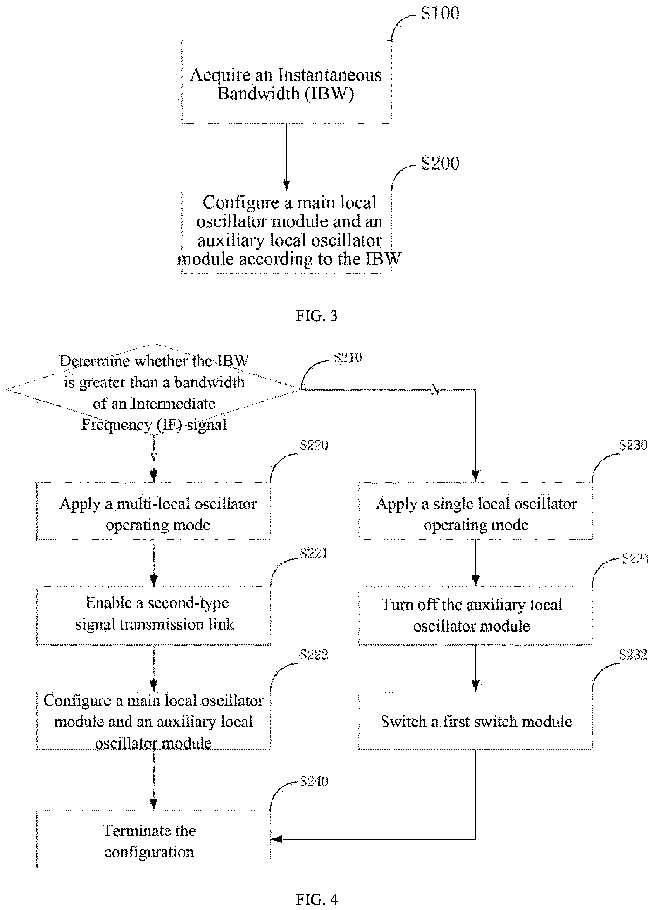

As shown in FIG. 3, FIG. 3 is a flowchart of a control method for a transceiver according to an embodiment of the present disclosure. The control method includes, but is not limited to, the following steps: S100, acquiring an IBW; and S200, configuring a main local oscillator module and an auxiliary local oscillator module according to the IBW.

The main local oscillator module 1010 and the auxiliary local oscillator module 1020 are configured with different operating frequencies.

At S 100, an IBW is acquired.

In some embodiments, acquiring the IBW enables the transceiver to adjust a mode of a local oscillator according to different IBWs.

At S200, a main local oscillator module and an auxiliary local oscillator module are configured according to the IBW.

In some embodiments, the main local oscillator module 1010 and the auxiliary local oscillator module 1020 are configured with different operating frequencies according to the IBW.

As shown in FIG. 4, FIG. 4 is a flowchart of a control method for a transceiver according to another embodiment of the present disclosure. The control method includes, but is not limited to, the following steps: S210, determining whether an IBW is greater than a bandwidth of an IF signal; S220, applying a multi-local oscillator operating mode; S221, enabling a second-type signal transmission link; S222, configuring a main local oscillator module and an auxiliary local oscillator module; S230, applying a single local oscillator operating mode; S231, turning off the auxiliary local oscillator module; S232, switching a first switch module; and S240, terminating the configuration.

At S210, it is determined whether an IBW is greater than a bandwidth of an IF signal.

In some embodiments, the IBW required by the transceiver is acquired, and it is determined whether the IBW is greater than the bandwidth of the IF signal. The determination of the IBW can realize switching of a mode of the transceiver. The transceiver includes an operating mode in which the main local oscillator module is used and an operating mode in which a double local oscillator module is used.

At S220, a multi-local oscillator operating mode is applied.

In some embodiments, when the IBW is greater than the bandwidth of the IF signal, the double local oscillator operating mode is enabled. The double local oscillator operating mode enables the transceiver to obtain a greater bandwidth, such that when the IBW is greater than the bandwidth of the IF signal, an operating frequency band of the transceiver can be adjusted to improve a signal bandwidth of the transceiver without using a digital-to-analog converter and an analog-to-digital converter with high sampling rates.

In some embodiments, when the IBW satisfying (m-1)^{∗}IF_BW<IBW<=m^{∗}IF_BW, X main local oscillator modules 1010 and Y auxiliary local oscillator modules 1020 are enabled, and the X main local oscillator modules 1010 and the Y auxiliary local oscillator modules 1020 are configured with different operating frequencies, where IF_BW denotes the bandwidth of the IF signal, and m=X+Y Main local oscillators in the main local oscillator modules 1010 and auxiliary local oscillators in the auxiliary local oscillator modules 1020 may be configured as identical local oscillators. The enabling of a plurality of main local oscillators and auxiliary local oscillators can further improve a bandwidth occupied by an air interface of the transceiver and realize full coverage of the transceiver in 5G frequency bands.

At S221, a second-type signal transmission link is enabled.

In some embodiments, when the multi-local oscillator operating mode is applied, the auxiliary local oscillators need to be enabled to perform signal link transmission.

At S222, a main local oscillator module and an auxiliary local oscillator module are configured.

In some embodiments, the main local oscillator module 1010 and the auxiliary local oscillator module 1020 are configured, and frequencies of the main local oscillator and the auxiliary local oscillator are adjusted, so as to adjust a bandwidth of the transceiver and then adjust a frequency band of the transceiver.

At S230, a single local oscillator operating mode is applied.

In some embodiments, when the IBW is less than or equal to the bandwidth of the IF signal, the single local oscillator operating mode is enabled to realize compatibility of the transceiver in some cases.

At S231, the auxiliary local oscillator module is turned off.

In some embodiments, when the transceiver is in a single local oscillator state, the auxiliary local oscillator module is powered off, so as to reduce energy consumption of the transceiver and prolong the service life of the transceiver.

At S232, a first switch module is switched.

In some embodiments, the first switch module 1070 is switched to switch the transceiver to a single local oscillator operating state.

At S240, the configuration is terminated.

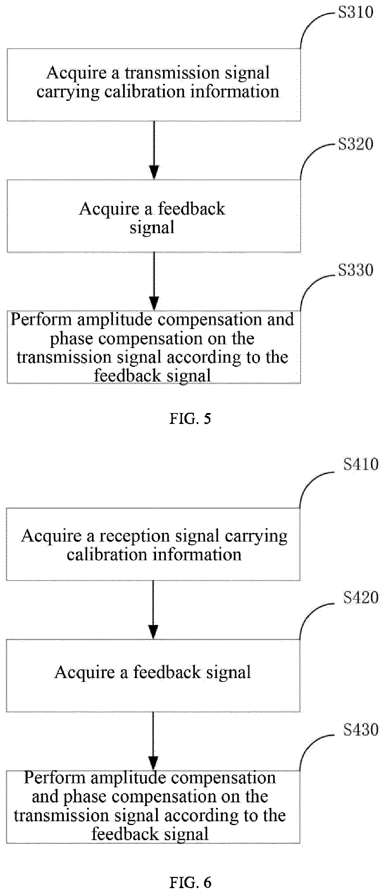

As shown in FIG. 5, FIG. 5 is a flowchart of a control method for a transceiver according to an embodiment of the present disclosure. The control method includes, but is not limited to, the following steps: S301, acquiring a transmission signal carrying calibration information; S302, acquiring a feedback signal; and S303, performing amplitude compensation and phase compensation on the transmission signal according to the feedback signal.

At S310, a transmission signal carrying calibration information is acquired.

In some embodiments, a transmission signal carrying calibration information is alternately sent by means of the first-type signal transmission link 1030 and the second-type signal transmission link 1040. A feedback signal from the calibration link is acquired. The feedback signal is obtained by coupling the transmission signal.

At S320, a feedback signal is acquired.

In some embodiments, amplitude compensation and phase compensation are performed on the transmission signal according to the feedback signal.

At S330, amplitude compensation and phase compensation are performed on the transmission signal according to the feedback signal.

In some embodiments, amplitude compensation and phase compensation are performed on the transmission signal according to the feedback signal. Performing amplitude compensation and phase compensation on the transmission signal can increases a recognition rate of signals and reduce a requirement for signal demodulation.

As shown in FIG. 6, FIG. 6 is a flowchart of a control method for a transceiver according to an embodiment of the present disclosure. The control method includes, but is not limited to, following steps: S401, acquiring a received signal carrying calibration information; S402, acquiring a feedback signal; and S403, performing amplitude compensation and phase compensation according to the acquired feedback signal.

At S410, a received signal carrying calibration information is acquired.

In some embodiments, the calibration signal carrying calibration information is transmitted by means of the calibration link, and the calibration signal is respectively coupled with a first reception signal of the first-type signal transmission link 1030 and a second reception signal of the second-type signal transmission link 1040. The first reception signal coupled with the calibration signal and the second reception signal coupled with the calibration signal are alternately acquired.

In some embodiments, a transmission signal carrying calibration information is alternately sent by means of the first-type signal transmission link 1030 and the second-type signal transmission link 1040.

In some embodiments, the calibration signal carrying calibration information is transmitted by means of the calibration link, and the calibration signal is respectively coupled with a first reception signal of the first-type signal transmission link 1030 and a second reception signal of the second-type signal transmission link 1040. The first reception signal coupled with the calibration signal and the second reception signal coupled with the calibration signal are alternately acquired.

At S420, a feedback signal is acquired.

In some embodiments, a feedback signal from the calibration link is acquired. The feedback signal is obtained by coupling the transmission signal.

At S430, amplitude compensation and phase compensation are performed according to the acquired feedback signal.

In some embodiments, amplitude compensation and phase compensation are performed on the first reception signal and the second reception signal respectively according to the calibration signal.

In some embodiments, amplitude compensation and phase compensation are performed on the transmission signal according to the feedback signal.

In some embodiments, amplitude compensation and phase compensation are performed on the first reception signal and the second reception signal respectively according to the calibration signal.

In addition, an embodiment of the present disclosure further provides a computer-readable storage medium. The computer-readable storage medium stores a computer-executable instruction which, when executed by a processor or a controller, for example, by a processor in the above structure embodiment, causes the processor to implement the control method in the above embodiment.

In an embodiment of the present disclosure, a transceiver includes a main local oscillator module, an auxiliary local oscillator module, a first-type signal transmission link, a second-type signal transmission link, and a control processing module. The first-type signal transmission link includes a first-type mixer. The first-type mixer is connected to the main local oscillator module. The second-type signal transmission link includes a second-type mixer. The second-type mixer is connected to the auxiliary local oscillator module. The control processing module is connected to the main local oscillator module and the auxiliary local oscillator module and configured to configure the main local oscillator module and the auxiliary local oscillator module with different operating frequencies according to an IBW. In a case where the IF bandwidth of the transceiver is not changed, by switching an operating mode of the local oscillator module and dividing the power , the requirements for the sampling rates of the digital-to-analog converter and the analog-to-digital converter are reduced, and the bandwidth occupied by the air interface of the transceiver can be adjusted according to IBWs of signals in different frequency bands without using analog-to-digital and digital-to-analog converters with high sampling rates, thereby realizing transmitting and receiving of 5G millimeter wave signals in different frequency bands.

In a case where an IF bandwidth is not changed, by controlling an operating frequency of the local oscillator module, requirements for the sampling rates of the digital-to-analog converter and the analog-to-digital converter are reduced, a requirement for image frequency suppression in digital-to-analog conversion or analog-to-digital conversion is reduced, and software resources to be consumed when IF signals are subjected to digital up-conversion and digital down-conversion are reduced, so that 5G millimeter wave signals in different frequency bands can be transmitted and received.

Those having ordinary skills in the art may understand that all or some of the steps in the method and the system disclosed above may be implemented as software, firmware, hardware, and suitable combinations thereof. Some or all of the physical components may be implemented as software executed by a processor such as a central processing unit, a digital signal processor or a microprocessor, or may be implemented as hardware or an integrated circuit such as an application-specific integrated circuit. Such software may be distributed on a computer-readable medium, which may include a computer storage medium (or non-transient medium) and a communication medium (or a transient medium). As is well known to those having ordinary skills in the art, the term "computer storage medium" includes volatile and nonvolatile, removable and non-removable media implemented in any method or technology for storing information (such as computer-readable instructions, data structures, program modules, or other data). The computer storage medium includes, but is not limited to, a Random Access Memory (RAM), a Read-Only Memory (ROM), an Electrically Erasable Programmable Read-Only Memory (EEPROM), a flash memory or other memory technologies, a Compact Disc Read-Only Memory (CD-ROM), a Digital Versatile Disk (DVD) or other optical storage, magnetic cassette, magnetic tape, magnetic disk storage or other magnetic storage apparatuses, or any other media that can be configured to store desired information and can be accessed by a computer. In addition, as is well known to those having ordinary skill in the arts, the communication medium typically includes computer-readable instructions, data structures, program modules or other data in a modulated data signal such as a carrier wave or other transport mechanisms, and may include any information delivery medium.

Some embodiments of the present disclosure are described above, and the present disclosure is not limited thereto. Those having ordinary skills in the art may make a variety of equivalent variations or replacements without departing from the scope of the present disclosure, all of which fall within the scope defined in the claims of the present disclosure.

## Claims

1. A transceiver, comprising:
at least one main local oscillator module;
at least one auxiliary local oscillator module;
at least one first-type signal transmission link, comprising a first-type mixer connected to the main local oscillator module;
at least one second-type signal transmission link, comprising a second-type mixer connected to the auxiliary local oscillator module; and
a control processing module, connected to the main local oscillator module and the auxiliary local oscillator module, and configured to configure the main local oscillator module and the auxiliary local oscillator module with different operating frequencies according to an Instantaneous Bandwidth, IBW.

2. The transceiver of claim 1, further comprising at least one first power divider and at least one second power divider, wherein the first-type mixer is connected to the main local oscillator module by means of the first power divider, and the second-type mixer is connected to the auxiliary local oscillator module by means of the second power divider.

3. The transceiver of claim 2, further comprising at least one first switch module, wherein, the first switch module comprises a first switch control terminal, a first switch movable contact, a first fixed contact of the first switch, and a second fixed contact of the first switch, the first switch movable contact is connected to the second power divider, the first fixed contact of the first switch is connected to the first power divider, the second fixed contact of the first switch is connected to the auxiliary local oscillator module, and the first switch control terminal is connected to the control processing module.

4. The transceiver of claim 3, wherein, in response to the IBW being less than or equal to a bandwidth of an Intermediate Frequency, IF, signal, the control processing module controls the first switch module to connect to the first fixed contact of the first switch to enable the main local oscillator module; and in response to the IBW being greater than the bandwidth of the IF signal, the control processing module controls the first switch module to connect to the second fixed contact of the first switch to enable the main local oscillator module and the auxiliary local oscillator module.

5. The transceiver of claim 3 or 4, further comprising a second switch module, a third power divider, and a calibration link configured to calibrate a transmission signal, wherein, the calibration link is coupled to the first-type signal transmission link and the second-type signal transmission link respectively by means of the third power divider, and the calibration link comprises a calibration mixer connected to the main local oscillator module and the auxiliary local oscillator module by means of the second switch module.

6. The transceiver of claim 5, further comprising a fourth power divider, wherein the second switch module comprises a second switch control terminal, a second switch movable contact, a first fixed contact of the second switch, and a second fixed contact of the second switch, the second switch movable contact is connected to the calibration mixer, the first fixed contact of the second switch is connected to the first power divider, the second fixed contact of the second switch is connected with the auxiliary local oscillator module by means of the fourth power divider, and the second switch control terminal is connected to the control processing module.

7. The transceiver of claim 2, further comprising a third switch module and a fourth switch module, wherein, each of the first-type mixers is respectively connected to each of the first power dividers and each of the second power dividers by means of the third switch module, and each of the second-type mixers is respectively connected to each of the first power dividers and each of the second power dividers by means of the fourth switch module.

8. The transceiver of claim 7, further comprising a fifth switch module, a fifth power divider, and a calibration link configured to calibrate a transmission signal, wherein, the calibration link is coupled with the first-type signal transmission link and the second-type signal transmission link respectively by means of the fifth power divider, and the calibration link comprises a calibration mixer connected to the main local oscillator module and the auxiliary local oscillator module by means of the fifth switch module.

9. The transceiver of claim 8, further comprising at least one sixth power divider and at least one seventh power divider, wherein, the main local oscillator module is connected to the first power divider and the fifth switch module by means of the sixth power divider, and the auxiliary local oscillator module is connected to the second power divider and the fifth switch module by means of the seventh power divider.

10. A control method for a transceiver, wherein, the transceiver comprises at least one main local oscillator module, at least one auxiliary local oscillator module, at least one first-type signal transmission link, and at least one second-type signal transmission link; the first-type signal transmission link comprises a first-type mixer connected to the main local oscillator module, and the second-type signal transmission link comprises a second-type mixer connected to the auxiliary local oscillator module,
the control method comprising:
acquiring an Instantaneous Bandwidth, IBW; and
configuring the main local oscillator module and the auxiliary local oscillator module with different operating frequencies according to the IBW.

11. The control method of claim 10, wherein, configuring the main local oscillator module and the auxiliary local oscillator module with different operating frequencies according to the IBW, comprises:
configuring the main local oscillator module and the auxiliary local oscillator module with different operating frequencies in response to the IBW being greater than a bandwidth of an IF signal.

12. The control method of claim 10, wherein, configuring the main local oscillator module and the auxiliary local oscillator module with different operating frequencies according to the IBW, comprises:
in response to the IBW satisfying (m-1)^{∗}IF_BW<IBW<=m^{∗}IF_BW, enabling X main local oscillator modules and Y auxiliary local oscillator modules, and configuring the X main local oscillator modules and the Y auxiliary local oscillator modules with different operating frequencies, wherein IF_BW denotes the bandwidth of the IF signal, and m=X+Y.

13. The control method of any one of claims 10 to 12, wherein, the transceiver further comprises a second switch module, a third power divider, and a calibration link, the calibration link is coupled with the first-type signal transmission link and the second-type signal transmission link respectively by means of the third power divider, the calibration link comprises a calibration mixer, and the calibration mixer connected to the main local oscillator module and the auxiliary local oscillator module by means of the second switch module,
the control method further comprising:
alternately sending a transmission signal carrying calibration information via the first-type signal transmission link and the second-type signal transmission link;
acquiring a feedback signal from the calibration link, wherein the feedback signal is obtained by coupling the transmission signal; and
performing amplitude compensation and phase compensation on the transmission signal according to the feedback signal.

14. The control method of claim 13, further comprising:
transmitting a calibration signal carrying calibration information via the calibration link, and coupling the calibration signal with a first reception signal of the first-type signal transmission link and a second reception signal of the second-type signal transmission link, respectively;
alternately acquiring the first reception signal coupled with the calibration signal and the second reception signal coupled with the calibration signal; and
performing amplitude compensation and phase compensation on the first reception signal and the second reception signal respectively according to the calibration signal.

15. A computer-readable storage medium storing a computer-executable instruction which, when executed by a processor, causes the processor to perform the control method of any one of claims 10 to 14.
